# FASCICULE DE BREVET EUROPEEN

(11) **EP 1 764 836 B1**
(45) Date de publication et mention de la délivrance du brevet: **13.08.2008**
(21) Numéro de dépôt: 06120971.4
(22) Date de dépôt: 20.09.2006
(51) Int. Cl.: H01L 27/146

(54) **Structure de montage d'un objectif mobile au-dessus d'un capteur optique**
Montagevorrichtung für die Justierung eines Objektivs vor einem optischen Detektor
Structure for mounting a mobile objective over an optical sensor

(30) Priorité: 20.09.2005 FR 0552825
(43) Date de publication de la demande: 21.03.2007
(73) Titulaire: ST MICROELECTRONICS S.A., 92120 Montrouge (FR)
(72) Inventeur: Saugier, Eric, 38190, Villard Bonnot (FR)
(74) Mandataire: de Beaumont, Michel

(56) Documents cités:
- EP-A- 1 475 960
- US-A1- 2004 262 705

## Description

### Domaine de l'invention

La présente invention concerne de façon générale la réalisation d'un système de prise de vues - appareil photographique ou caméra - électronique à focale variable pour obtenir une mise au point ou un effet zoom.

### Exposé de l'art antérieur

De façon générale, un appareil photographique ou une caméra électronique comprend une puce semiconductrice sur laquelle sont formés un réseau de capteurs optiques et éventuellement des circuits de traitement associés. En face de la puce est disposée une lentille ou plus généralement un objectif optique dont l'axe correspond à un axe orthogonal au centre du réseau de capteurs optiques.

La présente invention concerne plus particulièrement un système optique à focale variable, c'est-à-dire un système dans lequel le plan de l'objectif peut être déplacé dans la direction de l'axe optique, parallèlement au plan du capteur. Pour cela, le montage d'objectif comprend un moteur pour déplacer l'objectif selon l'axe optique. Ce moteur est un moteur électrique qui est commandé par des circuits qui sont associés à la puce de capteurs ou qui sont disposés sur une autre puce montée sur le même support que la puce de capteurs. Ce support est généralement une plaque de type de carte de circuits imprimés. Il faut alors assurer une liaison électrique entre des plots sur cette carte de circuits imprimés et des broches de connexion du moteur.

Les diverses solutions connues pour réaliser le montage d'un système de prise de vues à focale variable sont relativement lourdes et présentent toutes divers inconvénients.

Dans certaines solutions classiques, les connecteurs du moteur sont reliés aux plots sur la carte optique par une liaison flexible, ce qui implique des coûts de montage relativement élevés du fait que cela nécessite des soudures. De plus, de telles soudures sont généralement une source de fragilité du système électrique.

Dans certaines solutions classiques, la monture de lentille est collée sur le support (la carte de circuits imprimés) du capteur. Toutefois, ce collage devant être fait de façon que l'axe optique de l'objectif et l'axe perpendiculaire au centre de la puce de capteurs soient confondus, il faut prévoir des moyens complexes, coûteux et longs à utiliser, de positionnement relatif en XY de la puce de capteurs et de la monture d'objectif.

Le document US 2004/262705 A1 décrit une structure de montage d'un objectif mobile.

### Résumé de l'invention

Ainsi, un objet de la présente invention est de prévoir un système de montage et de connexion d'un objectif mobile sur une carte support de puce de capteurs optiques qui pallie les inconvénients de l'art antérieur.

Un objet plus particulier de la présente invention est de prévoir un tel montage qui soit simple et peu coûteux à réaliser.

Pour atteindre ces objets ainsi que d'autres, la présente invention prévoit une structure de montage d'un objectif mobile au-dessus d'un capteur optique monté sur une carte support, comprenant un capot monté sur la carte support et comportant une ouverture en regard du capteur, ce capot ayant une surface externe conique d'axe orthogonal à la carte support ; et un châssis comprenant des premier et deuxième éléments, mobiles en translation l'un par rapport à l'autre sous l'action d'un moteur électrique, le premier élément de châssis ayant une surface interne conique adaptée à s'accoupler avec la surface externe conique du capot pour assurer son positionnement et pour mettre des lames de connexion élastiques d'une partie fixe du moteur en contact avec des plots formés sur la carte support, et le deuxième élément de châssis portant l'objectif et une partie mobile en translation du moteur.

Selon un mode de réalisation de la présente invention, les surfaces coniques externe et interne comprennent des moyens de clips complémentaires.

Selon un mode de réalisation de la présente invention, les premier et deuxième éléments de châssis sont liés l'un à l'autre par des moyens de guidage complémentaires en translation dans la direction de l'axe.

Selon un mode de réalisation de la présente invention, les moyens de guidage comprennent des tiges solidaires du premier élément de châssis et des ouvertures formées dans le deuxième élément de châssis.

Selon un mode de réalisation de la présente invention, le premier élément de châssis a la forme générale d'une bague.

Selon un mode de réalisation de la présente invention, le deuxième élément de châssis est constitué d'une bague externe portant la partie mobile du moteur et comportant les moyens de guidage et d'une bague interne qui vient se visser à l'intérieur de la première bague.

Selon un mode de réalisation de la présente invention, une lame de filtre est montée au niveau de l'ouverture du capot.

La présente invention prévoit aussi un système de prise de vues à focale variable comprenant une structure de montage d'un objectif mobile au-dessus d'un capteur optique du type ci-dessus.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue éclatée schématique d'un assemblage d'une puce contenant un réseau de capteurs optiques et d'un objectif à distance focale variable selon la présente invention ; et
la figure 2 est une vue en perspective d'un exemple de réalisation détaillé de la présente invention.

### Description détaillée

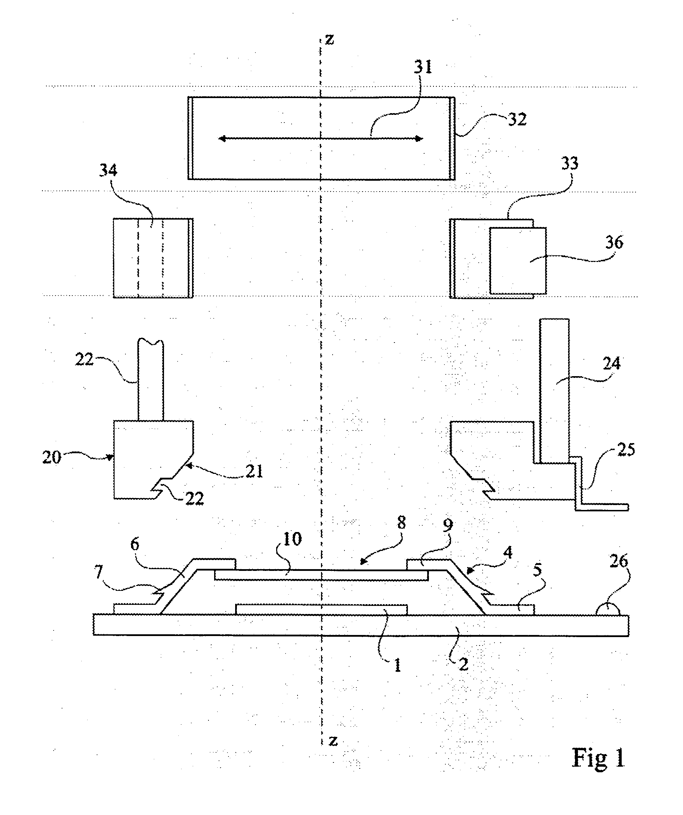

Par souci de clarté, de mêmes éléments ont été désignés par de mêmes références aux différentes figures et, de plus, la figure 1 n'est pas tracée à l'échelle.

La figure 1 représente un mode de réalisation selon la présente invention d'une structure d'objectif mobile associée à un capteur optique. Le capteur optique est constitué d'une puce de circuit intégré 1 montée sur une carte support 2, par exemple une carte de circuits imprimés qui porte éventuellement d'autres composants électroniques, et qui est munie de moyens de connexion entre ces composants et éventuellement de moyens d'enfichage dans un connecteur.

La présente invention prévoit d'associer à la carte support 2 un capot 4. Ce capot comprend des parties 5 d'appui sur la carte support 2 et une partie en forme de cône 6, le cône ayant son sommet à l'opposé de la carte de circuits imprimés et ayant son axe aligné avec la normale ZZ au centre du capteur optique 1. Les flancs du cône comprennent des moyens de clips 7. Le cône peut être à section circulaire ou à section carrée, ou avoir toute autre forme de section choisie, le terme "conique" devant être compris comme incluant le terme "pyramidal". Une partie supérieure du capot 4 comprend une ouverture 8 disposée en regard du capteur 1. Cette ouverture 8 est par exemple définie dans des parties horizontales supérieures 9 du capot auxquelles est de préférence fixée une lame 10 d'un matériau filtrant les rayonnements infrarouges, si on veut obtenir un dispositif optique sensible seulement à la lumière visible. Tout moyen de filtrage approprié, tel qu'une lame de verre éventuellement revêtue d'un filtre approprié peut être utilisé.

L'objectif est monté dans un châssis constitué de deux éléments mobiles l'un par rapport à l'autre. Le premier élément de châssis 20 a la forme générale d'une bague comportant du côté de sa face inférieure une surface conique 21 complémentaire de la surface conique 6 du capot 4. Cette surface conique comprend également un élément de clips 22 complémentaire du clips 7 formé sur la surface conique 6. On a représenté ici le clips 7 comme un élément en relief et le clips complémentaire 22 comme un élément en creux. Toute autre forme de couple de structures permettant un agrafage pourra être utilisée par l'homme de l'art.

Ainsi, quand la bague 20 est positionnée sur le capot 4, elle est parfaitement ajustée par rapport à ce capot dans le plan XY, c'est-à-dire le plan de la carte de circuits imprimés 2, grâce au montage à emboîtement conique et elle est maintenue fixe par le système de clips. Il existe seulement éventuellement une imprécision dans la direction verticale mais, étant donné que la présente invention prévoit un objectif déplaçable dans la direction de l'axe vertical, ce jeu pourra être rattrapé. Au lieu des clips, on pourrait prévoir un collage, ce qui annule le jeu vertical.

Au premier élément de châssis 20 sont associés rigidement, d'une part des éléments de guidage 22, par exemple des tiges verticales destinées à recevoir à coulissement le deuxième élément de châssis, d'autre part un premier élément, ou élément fixe, 24 d'un moteur électrique. Selon un aspect de l'invention, des lames de connexion 25 assurent la connexion entre des bornes du moteur 24 et des plots 26 disposés sur la carte support. Ces lames de connexion 25 sont des lames souples qui, quand la bague 20 est agrafée sur le cône 4, viennent en contact élastique à pression avec les plots 26. Bien entendu, alors qu'une forme très simple de lame de contact 25 a été représentée, diverses formes pourront être choisies par l'homme de l'art. On pourra aussi prévoir que les lames de contact 25 sont repliées sous la bague 20. Les plots peuvent être de simples métallisations de la carte support. A titre de variante, des lames rigides peuvent venir s'appuyer sur des plots élastiques.

Dans un mode de réalisation de la présente invention, l'objectif désigné de façon symbolique sous la référence 31 est disposé dans une bague 32 venant se visser dans une bague 33 constituant un deuxième élément de châssis. Bien entendu, l'ensemble des bagues 32 et 33 peut constituer une seule et même bague. La bague 33 comprend des moyens de guidage constitués par exemple d'ouvertures traversantes 34 venant s'enfiler à coulissement dans les tiges 22 solidaires de la bague 20 pour permettre un déplacement de la bague 33 selon l'axe Z. D'autres moyens de guidage en translation pourraient être choisis par l'homme de l'art. En outre, la bague 33 comprend une deuxième partie, ou partie mobile, de moteur 36 coopérant avec la partie fixe 24 et pouvant se déplacer verticalement sous l'action du moteur. On a représenté les premier et deuxième éléments de châssis sous forme de trois pièces éclatées. En fait, ces trois pièces pourront être pré-assemblées avant de monter l'ensemble de châssis sur le capot 4.

Lors de l'opération de montage châssis-capot, en raison de l'assemblage conique du châssis et du capot, on obtient un positionnement très précis dans le plan XY. C'est seulement selon l'axe Z qu'une légère imprécision peut se produire. Cette imprécision peut être rattrapée par un vissage plus ou moins grand de la bague 32 dans la bague 33, ou bien par une action du moteur 24-36 pour faire monter ou descendre l'objectif 31. On notera que, lors de l'opération de montage châssis-capot, on établit aussi le contact entre les lames de contact 25 et les plots de contact 26. Ainsi, un assemblage selon la présente invention, électrique et mécanique, peut être réalisé de façon rapide et simple sans nécessiter d'opération de soudure ni d'outillage spécifique de précision de positionnement XY.

Bien entendu, la présente invention est susceptible de diverses variantes et modifications qui apparaîtront à l'homme de l'art, notamment en ce qui concerne les formes des diverses pièces qui peuvent être choisies pour des raisons fonctionnelles, ergonomiques et/ou esthétiques. L'homme de l'art pourra aussi diviser certaines des pièces décrites en plusieurs pièces élémentaires. Par ailleurs, le moteur électrique de déplacement de l'objectif n'a pas été décrit, l'homme de l'art pouvant choisir divers types de moteurs selon l'application visée et diverses exigences pratiques.

La présente invention se prête bien à la réalisation d'appareils photographiques miniatures tels que ceux utilisés dans les téléphones portables. La demanderesse a réalisé un appareil selon l'invention dans lequel les dimensions dans le plan horizontal (dimensions de la carte 2) étaient de 12x12 mm², la hauteur étant de l'ordre de 7,5 mm.

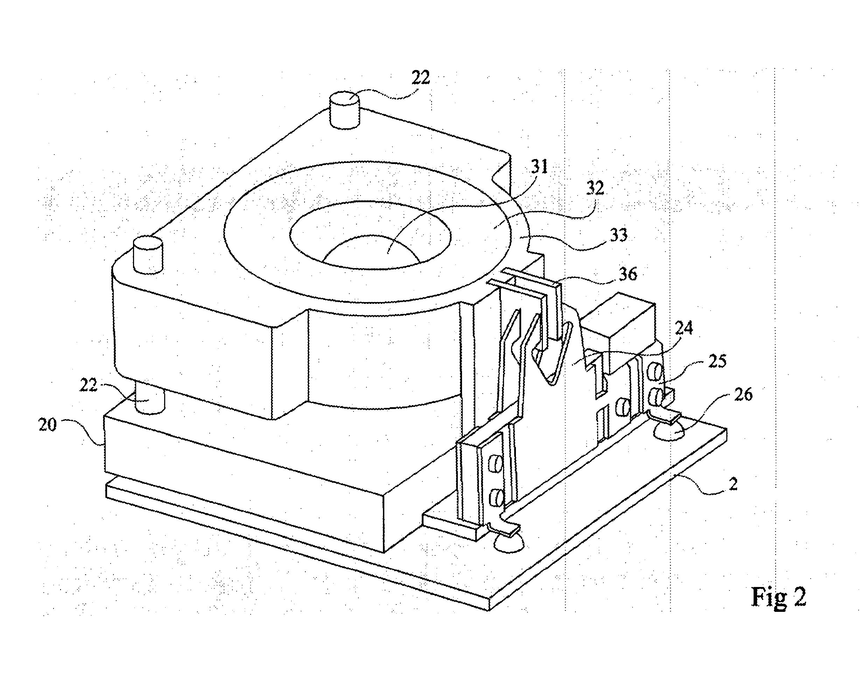

Un exemple détaillé d'un mode de réalisation de la structure selon l'invention est illustré dans la vue en perspective de la figure 2 dans laquelle de mêmes éléments qu'en figure 1 sont désignés par les mêmes références.

## Revendications

1. Structure de montage d'un objectif mobile au-dessus d'un capteur optique (1) monté sur une carte support (2), comprenant :
un capot (4) monté sur la carte support et comportant une ouverture en regard du capteur, ce capot ayant une surface externe conique (6) d'axe orthogonal à la carte support (2) ; et
un châssis comprenant des premier et deuxième éléments, mobiles en translation l'un par rapport à l'autre sous l'action d'un moteur électrique, le deuxième élément de châssis (32, 33) portant l'objectif (31) et une partie mobile en translation (36) du moteur**,caractérisé en ce que**
le premier élément de châssis (20) a une surface interne conique (21) adaptée à s'accoupler avec la surface externe conique (6) du capot pour assurer son positionnement et pour mettre des lames de connexion (25) d'une partie fixe (24) du moteur en contact élastique avec des plots (26) sur la carte support.

2. Structure selon la revendication 1, dans laquelle les surfaces coniques externe et interne (6, 21) comprennent des moyens de clips complémentaires (7, 22).

3. Structure selon la revendication 1, dans laquelle les premier et deuxième éléments de châssis sont liés l'un à l'autre par des moyens de guidage complémentaires en translation dans la direction de l'axe.

4. Structure selon la revendication 3, dans laquelle les moyens de guidage comprennent des tiges (22) solidaires du premier élément de châssis et des ouvertures (34) formées dans le deuxième élément de châssis.

5. Structure selon la revendication 1, dans laquelle le premier élément de châssis a la forme générale d'une bague.

6. Structure selon la revendication 1, dans laquelle le deuxième élément de châssis est constitué d'une bague externe portant la partie mobile du moteur et comportant les moyens de guidage (34) et d'une bague interne (32) qui vient se visser à l'intérieur de la première bague (33).

7. Structure selon la revendication 1, dans laquelle une lame de filtre (10) est montée au niveau de l'ouverture du capot.

8. Système de prise de vues à focale variable comprenant une structure de montage d'un objectif mobile au-dessus d'un capteur optique selon l'une quelconque des revendications 1 à 7.

## Claims

1. A structure of assembly of a mobile objective above an optical sensor (1) assembled on a support board (2), comprising:
a cover (4) assembled on the support board and comprising an opening facing the sensor, this cover having a conical external surface (6) with an axis orthogonal to the support board (2); and
a frame comprising first and second elements, shiftable with respect to each other under the action of an electric motor, the second frame element (32, 33) supporting the objective (31) and a shiftable portion (36) of the motor, **characterized in that** the first frame element (20) having a conical internal surface (21) capable of mating with the conical external surface (6) of the cover to ensure its positioning and to put connection blades (25) of a fixed portion (24) of the motor in resilient contact with pads (26) on the support board.

2. The structure of claim 1, wherein the external and internal conical surfaces (6, 21) comprise complementary clipping means (7, 22).

3. The structure of claim 1, wherein the first and second frame elements are linked to each other by complementary means of shifting along the axis direction.

4. The structure of claim 3, wherein the guiding means comprise rods (22) moving along with the first frame element and openings (34) formed in the second frame element.

5. The structure of claim 1, wherein the first frame element has the general shape of a ring.

6. The structure of claim 1, wherein the second frame element is formed of an external ring supporting the mobile portion of the motor and comprising the guiding means (34) and of an internal ring (32) which screws inside of the first ring (33).

7. The structure of claim 1, wherein a filter blade (10) is assembled at the cover opening level.

8. A variable-focus shooting system comprising a structure of assembly of a mobile objective above the optical sensor of any of claims 1 to 7.

## Patentansprüche

1. Montagestruktur eines bewegbaren Objektivs über einem optischen Sensor (1), der auf einer Tragplatte (2) montiert ist, welche Folgendes aufweist:
eine Abdeckung (4), die auf der Tragplatte montiert ist und eine Öffnung aufweist, die zum Sensor weist, wobei diese Abdeckung eine konische Außenfläche (6) mit einer Achse senkrecht zur Tragplatte (2) hat; und
einen Rahmen, der erste und zweite Elemente aufweist, die mit Bezug zueinander unter der Wirkung eines Elektromotors verschiebbar sind, wobei das zweite Rahmenelement (32, 33) das Objektiv (31) und einen verschiebbaren Teil (36) des Motors trägt,
**dadurch gekennzeichnet, dass** das erste Rahmenelement (20) eine konische Innenfläche (21) hat, die mit der konischen Außenfläche (6) der Abdeckung zusammenpassen kann, um ihre Positionierung sicherzustellen, und um Verbindungsansätze (25) eines festen Teils (24) des Motors in elastischen Kontakt mit Kissen (26) auf der Tragplatte zu bringen.

2. Struktur nach Anspruch 1, wobei die äußeren und inneren konischen Flächen (6, 21) entgegengesetzte Clip- bzw. Rastmittel (7, 22) aufweisen.

3. Struktur nach Anspruch 1, wobei die ersten und zweiten Rahmenelemente miteinander durch entgegengesetzte Verschiebemittel entlang der axialen Richtung verbunden sind.

4. Struktur nach Anspruch 3, wobei die Führungsmittel Stangen (22) aufweisen, die sich zusammen mit dem ersten Rahmenelement bewegen, und Öffnungen (34), die in dem zweiten Rahmenelement ausgebildet sind.

5. Struktur nach Anspruch 1, wobei das erste Rahmenelement die allgemeine Form eines Rings hat.

6. Struktur nach Anspruch 1, wobei das zweite Rahmenelement aus einem äußeren Ring geformt ist, welches den mobilen Teil des Motors trägt und die Führungsmittel (34) aufweist, und aus einem inneren Ring (32), der in den ersten Ring (33) geschraubt ist.

7. Struktur nach Anspruch 1, wobei ein Filteransatz (10) an dem Abdeckungsöffnungsniveau montiert ist.

8. Aufnahmesystem mit variablem Fokus, welches eine Struktur einer Anordnung eines bewegbaren Objektivs über dem optischen Sensor nach einem der Ansprüche 1 bis 7 aufweist.
